# FASCICULE DE BREVET EUROPEEN

(11) **EP 2 785 556 B1**
(45) Date de publication et mention de la délivrance du brevet: **16.11.2016**
(21) Numéro de dépôt: 12795418.8
(22) Date de dépôt: 30.11.2012
(51) Int. Cl.: B60Q 1/00, B60Q 3/02

(54) **DISPOSITIF DE POSITIONNEMENT ET DE FIXATION D'UN ELEMENT D'AFFICHAGE ET DISPOSITIF D'AFFICHAGE**
VORRICHTUNG ZUR POSITIONIERUNG UND SICHERUNG EINES ANZEIGEELEMENTS UND ANZEIGEVORRICHTUNG DAMIT
DEVICE FOR POSITIONING AND SECURING A DISPLAY ELEMENT AND DISPLAY DEVICE

(30) Priorité: 02.12.2011 DE 102011120052; 29.05.2012 FR 1201536
(43) Date de publication de la demande: 08.10.2014
(73) Titulaire: Johnson Controls Automotive Electronics SAS, 95892 Cergy-Pontoise Cedex (FR)
(72) Inventeur: MACQUET, Eric, F-95320 Saint Leu La Forêt (FR)
(74) Mandataire: Schwöbel, Thilo K.
(86) Numéro de dépôt international: PCT/EP2012/074123
(87) Numéro de publication internationale: WO 2013/079675

(56) Documents cités:
- US-A1- 2002 086 645
- US-A1- 2006 034 041
- US-A1- 2006 098 134
- US-A1- 2011 012 931

## Description

La présente invention concerne un dispositif de positionnement et de fixation d'un élément d'affichage et un dispositif d'affichage, notamment pour un véhicule automobile, comprenant un tel dispositif de positionnement et de fixation.

Des dispositifs de positionnement et de fixation sont connus, par exemple de la demande de brevet français no. FR 2674295 A1. Cette publication propose de prévoir un bloc de matériau souple destiné à supporter un élément dans un appareil, l'ensemble bloc-élément étant serré entre un premier et un deuxième support, les supports comprenant des moyens de positionnement du bloc et des moyens de positionnement de l'élément, les supports comprenant également des moyens permettant leur mutuelle fixation.

Un inconvénient d'un tel dispositif selon l'art connu consiste dans la nécessité de prévoir une multitude de différents éléments et pièces ce qui rend la production d'un tel dispositif relativement coûteux et volumineux et augmente le poids d'un tel dispositif.

Un autre inconvénient d'un tel dispositif selon l'art connu consiste dans la durée du montage qui augmente en fonction du nombre de pièces complémentaires à assembler.

Par ailleurs, on connait dans l'état de la technique des dispositifs d'affichage disposés sur ou dans une partie d'équipement intérieur d'un véhicule, par exemple un tableau de bord ou une console centrale. Un dispositif d'affichage comprend généralement un élément d'affichage servant à réaliser un affichage d'informations et une plaque conductrice / carte imprimée électronique couplée à l'élément d'affichage et pourvue d'un agencement de branchement servant à faire fonctionner l'élément d'affichage. L'élément d'affichage est en l'occurrence la plupart du temps entouré dans sa zone de bordure d'un élément obturateur de boîtier (ou élément de diaphragme). L'élément d'affichage peut par exemple prendre la forme d'un écran à cristaux liquides, notamment d'un écran de type TFT (en anglais : thin film transistor, transistor à couches minces). Les écrans TFT comportent une matrice composée de transistors à couches minces et permettent d'obtenir un élément d'affichage de bonne qualité optique pour un utilisateur.

La présente invention a notamment pour but de pallier aux inconvénients de l'art connu, et notamment ceux cités ci-dessus, et a également pour but de proposer un dispositif de positionnement et de fixation d'un élément d'affichage qui est facile à assembler qui assure une stabilité augmentée pendant la période d'utilisation du dispositif d'affichage.

Suivant l'invention, ce but est atteint par un dispositif de positionnement et de fixation pour le positionnement et la fixation d'un élément d'affichage par rapport à un boîtier, l'élément d'affichage étant essentiellement localisé dans un plan d'extension principale et abutant, dans une direction perpendiculaire au plan d'extension principale, au boîtier, le dispositif de positionnement et de fixation étant essentiellement localisé dans un autre plan d'extension principale parallèle au plan d'extension principale de l'élément d'affichage, le dispositif de positionnement et de fixation comprenant au moins un premier élément de compression abutant contre l'élément d'affichage ainsi qu'au moins un deuxième élément de compression abutant contre le boîtier.

Avec un tel dispositif de positionnement et de fixation, il est avantageusement possible de réaliser et le positionnement et la fixation de l'élément d'affichage de façon simple avec une seule pièce ce qui rend le montage de l'élément d'affichage simple et peu coûteux.

L'objectif selon la présente invention est atteint du fait d'un dispositif d'affichage comprenant un élément d'affichage servant à représenter des informations et une plaque conductrice / carte imprimée électronique couplée à l'élément d'affichage servant à faire fonctionner l'élément d'affichage, l'élément d'affichage étant entouré dans sa zone de bordure par un élément obturateur (ou élément de diaphragme) disposé dans un boîtier et un élément de fixation et/ou de maintien placé entre l'élément d'affichage et la plaque conductrice maintenant l'élément d'affichage dans une position définie par rapport à la plaque conductrice et au boîtier. L'élément de fixation et/ou de maintien prend en l'occurrence une forme flexible sur certains tronçons au moins. Il prend la forme d'un ressort à lames et comporte au moins sur certains tronçons un profil courbé en forme de zigzag dans le plan horizontal en contact avec un côté inférieur, dans la direction d'observation, de l'élément d'affichage et avec un côté supérieur, dans la direction d'observation, de la plaque conductrice. Il est particulièrement préféré que l'élément de fixation et/ou de maintien soit façonné en métal, par exemple en inox.

Un montage sans outil de l'élément d'affichage est rendu possible de façon avantageuse entre le boîtier et la plaque conductrice grâce à l'élément de fixation et/ou de maintien, de sorte qu'aucun élément de fixation supplémentaire n'est nécessaire pour disposer l'élément d'affichage dans le dispositif d'affichage et le boîtier. L'élément d'affichage est délimité à cette fin par l'élément de fixation et/ou de maintien en direction de la plaque conductrice, c'est-à-dire vers le bas dans la direction d'observation, et par l'élément obturateur en direction du boîtier, c'est-à-dire vers le haut dans la direction d'observation et est ainsi maintenu en place de façon optimale. La maîtrise du coût et de la complexité du dispositif d'affichage permet d'en rentablisiser la fabrication.

Le dispositif de positionnement et de fixation est prévu en un matériau électriquement conducteur, notamment en un métal ou un alliage de métaux.

L'avantage de réaliser le dispositif de positionnement et de fixation en un matériau électriquement conducteur réside dans le fait qu'il est ainsi possible de protéger l'élément d'affichage des influences négatives des décharges électriques, notamment électrostatiques.

Le premier élément de compression et le deuxième élément de compression sont reliés l'un à l'autre à la manière d'un ressort à lames.

Ainsi, il est avantageusement possible selon la présente invention de réaliser une fixation simple et durable de l'élément d'affichage dans le boîtier du dispositif d'affichage.

Selon l'invention il est prévu qu'une pluralité de premiers éléments de compression et un deuxième élément de compression sont reliés de manière d'un méandre, notamment en languette de ressort pliée, ou qu'une pluralité de deuxième éléments de compression et un premier élément de compression sont reliés de manière d'un méandre, notamment en languette de ressort pliée.

De par une telle réalisation du dispositif de positionnement et de fixation il est avantageusement possible de réaliser le dispositif de positionnement et de fixation de manière simple et peu couteux

Un perfectionnement préféré de l'invention réside également dans le fait que le dispositif de positionnement et de fixation forme un cadre.

Selon la présente invention, il est avantageusement possible de prévoir non seulement une fixation qui se prête à un montage rapide mais aussi une fixation sans bruit de cliquetis et une possibilité de contact électrique entre le dispositif de positionnement et de fixation et l'élément d'affichage.

Selon encore un autre mode de réalisation préféré, le dispositif de positionnement et de fixation est prévu en tant que cadre rectangulaire.

Un perfectionnement préféré de l'invention réside encore dans le fait que l'élément d'affichage abute, dans une direction perpendiculaire au plan d'extension principale, à un diaphragme du boîtier.

De par une telle réalisation du dispositif de positionnement et de fixation, il est avantageusement possible de réaliser un montage simple malgré le fait que l'élément d'affichage soit fixé par rapport au dispositif de positionnement et de fixation.

La présente invention concerne également un dispositif d'affichage, notamment pour un véhicule automobile, le dispositif d'affichage comprenant un élément d'affichage, un boîtier, et un dispositif de positionnement et de fixation selon la présente invention.

Un perfectionnement préféré de l'invention réside encore dans le fait que l'élément d'affichage comprend au moins un élément électroluminescent de type transistor à couche mince (TFT, thin film transistor) ou un élément électroluminescent à cristaux liquides (LCD, liquid crystal display).

D'autres caractéristiques et avantages de l'invention ressortiront à la lecture de la description qui suit d'un mode de réalisation particulier non limitatif de l'invention.

### BREVE DESCRIPTION DES DESSINS

L'invention sera mieux comprise grâce à la description ci-après, qui se rapporte à des modes de réalisation préférés, donnés à titre d'exemples non limitatifs, et expliqués avec référence aux dessins schématiques annexés, dans lesquels :
la figure 1 est une représentation de section d'un dispositif de positionnement et de fixation assemblé avec un élément d'affichage selon la présente invention,
la figure 2 est une représentation en élévation sur un dispositif d'affichage avec un élément d'affichage et un dispositif de positionnement et de fixation selon un premier mode de réalisation de la présente invention,
la figure 3 est une représentation en élévation sur un dispositif de positionnement et de fixation selon un premier mode de réalisation selon la présente invention, et
la figure 4 est une représentation en élévation sur un dispositif de positionnement et de fixation selon un deuxième mode de réalisation selon la présente invention.

### DESCRIPTION DES DESSINS

Les parties correspondantes sont associées aux mêmes références sur l'ensemble des figures.

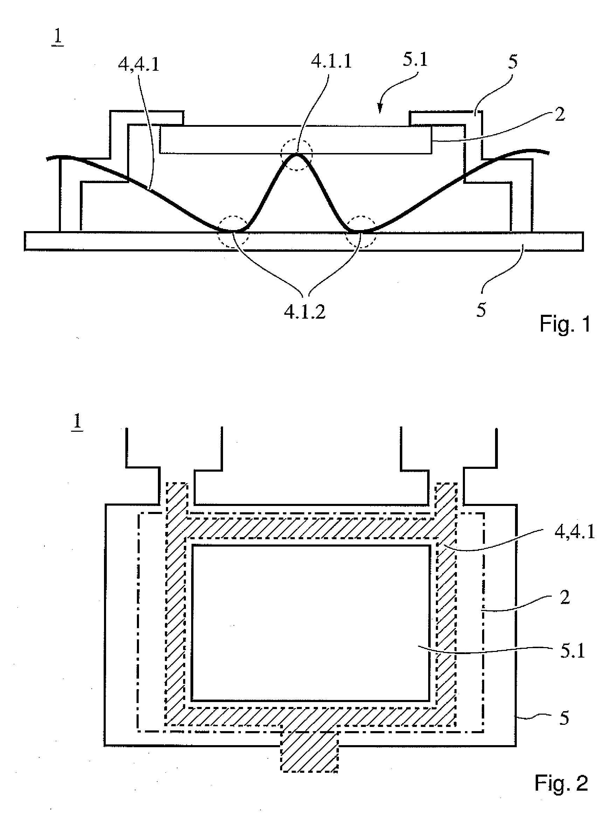

La figure 1 illustre une représentation en coupe d'un dispositif d'affichage 1 selon l'invention, comprenant un élément d'affichage 2, une plaque conductrice 3 (dans la suite aussi appelée carte imprimée électronique 3) et un élément de fixation et/ou de maintien 4 (dans la suite aussi appelé dispositif de positionnement et de fixation 4).

Le dispositif d'affichage 1 peut de préférence être disposé dans un véhicule, par exemple dans un tableau de bord ou une console centrale et sert à saisir et/ou afficher des informations destinées à un utilisateur. Le dispositif d'affichage 1 permet par exemple de réaliser un affichage d'image pour un système de navigation placé dans un véhicule.

L'élément d'affichage 2 prend dans le présent exemple de réalisation la forme d'un élément plat pouvant afficher des informations sur un côté frontal, c'est-à-dire un côté orienté vers un observateur, en fonction de signaux électriques reçus. L'élément d'affichage 2 peut par exemple prendre la forme d'un écran à cristaux liquides, notamment d'un écran de type TFT (thin film transistor). Les écrans TFT comportent une matrice composée de transistors à couches minces et permettent d'obtenir un élément d'affichage 2 de bonne qualité optique pour un utilisateur.

Les signaux électriques ainsi qu'une tension d'alimentation destinés à l'élément d'affichage 2 sont mis à disposition de la plaque conductrice 3 par le biais d'un agencement de branchement électrique. La plaque conductrice 3 est disposée à cette fin sous l'élément d'affichage 2, parallèlement dans la direction d'observation, et est couplée à lui sur le plan électrique (de façon non représentée) par le biais d'un câble. La plaque conductrice 3 comporte pour ce faire des composants électriques et électroniques permettant de faire fonctionner l'élément d'affichage 2.

L'élément de fixation et/ou de maintien (c'est à dire le dispositif de positionnement et de fixation) 4 prenant la forme, dans le présent exemple de réalisation, d'un ressort à lames 4.1 est disposé entre l'élément d'affichage 2 et la plaque conductrice 3, ledit ressort présentant au moins sur certains tronçons un profil incurvé en zigzag dans le plan horizontal. Le ressort à lames 4.1 / le dispositif de positionnement et de fixation 4.1 est de préférence façonné en métal, par exemple en inox. En l'occurrence les pointes 4.1.1 (aussi appelées premier élément de compression 4.1.1) orientées vers l'élément d'affichage 2 du ressort à lames 4.1 incurvé en zigzag entrent en contact avec un côté arrière de l'élément d'affichage 2, c'est-à-dire un côté inférieur, dans la direction d'observation, de l'élément d'affichage 2, et les pointes 4.1.2 (aussi appelées deuxième élément de compression 4.1.2) orientées vers la plaque conductrice du ressort à lames 4.1 incurvé en zigzag entrent en contact avec un côté supérieur de la plaque conductrice 3. Le ressort à lames 4.1 peut en l'occurrence être disposé de façon particulièrement préférée dans le dispositif d'affichage 1 sans moyen de fixation supplémentaire. Les pointes 4.1.1 du ressort à lames 4.1 prennent en l'occurrence de préférence une forme arrondie.

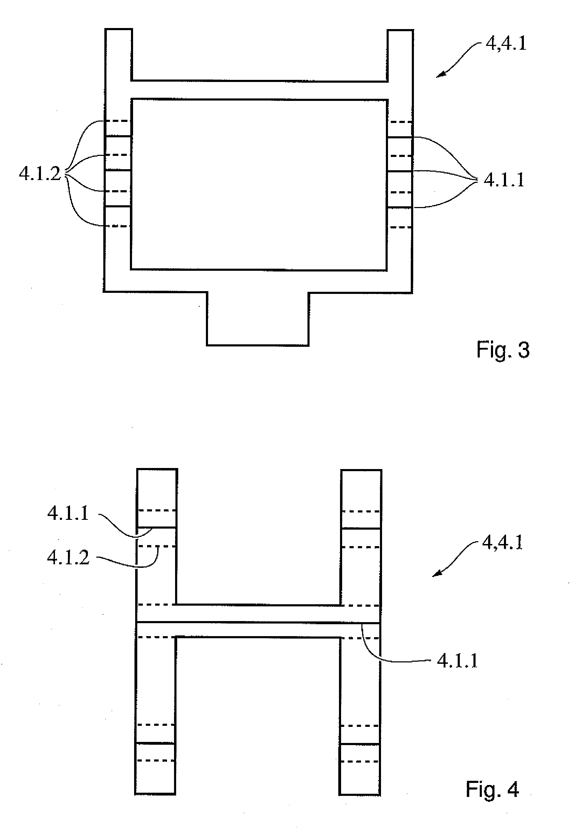

Le ressort à lames 4.1 (représenté de façon hachurée sur la figure 2) est en l'occurrence façonné, selon un premier mode de réalisation représenté sur les figures 2 et 3, de façon à correspondre à une zone de bordure périphérique de l'élément d'affichage 2, de façon à ce que celle-ci prenne, en vue en élévation, une forme approximativement tétraédrique avec des arrondis correspondants prévus dans une zone périphérique extérieure. Dans une variante de réalisation illustrée sur la figure 4, le ressort à lames 4.1 est façonné sur certains tronçons de façon correspondante à une zone de bordure périphérique de l'élément d'affichage 2 prenant un forme de H en vue en élévation.

Le ressort à lames 4.1 prend de façon préférée la forme d'un composant réalisé d'un seul tenant et peut être fabriqué facilement et à un bon prix, par exemple par le biais d'un procédé de pressage. En variante, le ressort à lames 4.1 est façonné par complémentarité de forces et/ou de formes et/ou de matières à partir de plusieurs parties reliées entre elles.

L'élément d'affichage 2, la plaque conductrice 3 et l'élément de fixation et/ou de maintien 4 sont disposés dans un boîtier 5 prenant la forme, dans le présent exemple de réalisation, d'un boîtier lumineux de console de tableau de bord de véhicule.

Le boîtier 5 comporte un dégradé périphérique, la deuxième marche présentant une périphérie extérieure plus réduite que la première marche. Un évidement prenant la forme d'un élément obturateur 5.1 est disposé dans la deuxième marche, la périphérie dudit évidement étant plus réduite que la périphérie extérieure de l'élément d'affichage 2.

L'élément d'affichage 2 est disposé sous l'élément obturateur dans la direction d'observation. L'élément d'affichage 2 est délimité en direction de la plaque conductrice 3, c'est-à-dire vers le bas dans la direction d'observation, par le biais de l'élément de fixation et/ou de maintien 4 et en direction du boîtier 5, c'est-à-dire vers le haut dans la direction d'observation, par le biais de l'élément obturateur 5.1, ce qui permet de le maintenir en place de façon optimale.

Un montage sans outil de l'élément d'affichage 2 dans le dispositif d'affichage 1 est ainsi avantageusement rendu possible par l'élément de fixation et/ou de maintien 4, rendant ainsi superflue l'utilisation d'éléments de fixation supplémentaires pour mettre en place une liaison par complémentarité de forces de l'élément d'affichage 2 avec le boîtier 5.

En variante ou en sus, le boîtier 5 peut comporter sur le côté intérieur des évidements de matière, par exemple sous la forme d'encoches dans lesquelles des sections de l'élément de fixation et/ou de maintien 4 sont disposées. L'élément d'affichage 2 peut alors également être maintenu en place lorsque la plaque conductrice 3 est comprimée, par exemple vers le bas dans la direction d'observation, et que les pointes 4.1.2 orientées vers la plaque conductrice 3 ne touchent plus le côté supérieur de la plaque conductrice 3.

### Liste des signes de référence :

- 1: Dispositif d'affichage
- 2: Élément d'affichage
- 3: Plaque conductrice / carte imprimée électronique
- 4: Élément de fixation et/ou de maintien
- 4.1: Ressort à lames
- 4.1.1: Pointes / premier(s) élément(s) de compression
- 4.1.2: Pointes / deuxième(s) élément(s) de compression
- 5: Boîtier
- 5.1: Élément obturateur / diaphragme

## Revendications

1. Dispositif de positionnement et de fixation (4, 4.1) pour le positionnement et la fixation d'un élément d'affichage (2) par rapport à un bottier (5), l'élément d'affichage (2) étant essentiellement localisé dans un plan d'extension principale et abutant, dans une direction perpendiculaire au plan d'extension principale, au boîtier (5),
le dispositif de positionnement et de fixation (4, 4.1) étant essentiellement localisé dans un autre plan d'extension principale parallèle au plan d'extension principale de l'élément d'affichage (2),
**caractérisé en ce que** le dispositif de positionnement et de fixation (4.4.1) comprenant au moins un premier élément de compression (4.1.1) abutant contre l'élément d'affichage (2) ainsi qu'au moins un deuxième élément de compression (4.1.2) abutant contre le bottier (5),.
le dispositif de positionnement et de fixation (4, 4.1) étant prévu en un matériau électriquement conducteur, notamment en un métal ou un alliage de métaux
**caractérisé en ce que** le premier élément de compression (4.1.1) et le deuxième élément de compression (4.1.2) sont reliés l'un à l'autre à la manière d'un ressort à lames et
qu'une pluralité de premiers éléments de compression (4.1.1) et un deuxième élément de compression (4.1.2) sont reliés de manière d'un méandre, notamment en languette de ressort pliée, ou.
une pluralité de deuxième éléments de compression (4.1.2) et un premier élément de compression (4.1.1) sont reliés de manière d'un méandre, notamment en languette de ressort pliée.

2. Dispositif de positionnement et de fixation (4, 4.1) selon la revendication 1, **caractérisé en ce que** le dispositif de positionnement et de fixation (4, 4.1) forme un cadre.

3. Dispositif de positionnement et de fixation (4, 4.1) selon l'une quelconque des revendications précédentes, **caractérisé en ce que** le dispositif de positionnement et de fixation (4, 4.1) est prévu en tant que cadre rectangulaire.

4. Dispositif de positionnement et de fixation (4, 4,1) selon l'une quelconque des revendications précédentes, **caractérisé en ce que** l'élément d'affichage (2) abute, dans une direction perpendiculaire au plan d'extension principale, à un diaphragme du boîtier (5).

5. Dispositif d'affichage (1), notamment pour un véhicule automobile, **caractérisé en ce que** le dispositif d'affichage (1) comprend un dispositif de positionnement et de fixation (4, 4.1) selon l'une quelconque des revendications précédentes et **en ce que** le dispositif d'affichage (1) comprend un élément d'affichage (2) et un boîtier (5).

6. Dispositif d'affichage (1) selon la revendication 5, **caractérisé en ce que** l'élément d'affichage (2) comprend au moins un élément électroluminescent de type transistor à couche mince (TFT, thin film transistor) ou un élément électroluminescent à cristaux liquides (LCD, liquid crystal display).

## Patentansprüche

1. Vorrichtung zur Positionierung und Sicherung (4, 4.1) zum Positionieren und zum Sichern eines Anzeigeelements (2) gegenüber einem Gehäuse (5),
wobei das Anzeigeelement (2) im Wesentlichen in einer Hauptausdehnungsebene angeordnet ist und in einer Richtung senkrecht zu der Hauptausdehnungsebene an das Gehäuse (5) stößt,
wobei die Vorrichtung zur Positionierung und Sicherung (4, 4.1) im Wesentlichen in einer anderen Hauptausdehnungsebene angeordnet ist, die parallel zu der Hauptausdehnungsebene des Anzeigeelements (2) ist,
**dadurch gekennzeichnet, dass** die Vorrichtung zur Positionierung und Sicherung (4, 4.1) mindestens ein erstes Kompressionselement (4.1.1), das gegen das Anzeigeelement (2) stößt, sowie mindestens ein zweites Kompressionselement (4.1.2) aufweist, das gegen das Gehäuse (5) stößt,
wobei die Vorrichtung zur Positionierung und Sicherung (4, 4.1) aus einem elektrisch leitenden Material, insbesondere aus einem Metall oder einer Metalllegierung, vorgesehen ist,
**dadurch gekennzeichnet, dass** das erste Kompressionselement (4.1.1) und das zweite Kompressionselement (4.1.2) in der Weise einer Blattfeder miteinander verbunden sind und
dass mehrere erste Kompressionselemente (4.1.1) und ein zweites Kompressionselement (4.1.2) nach Art eines Mäanders, insbesondere als gebogene Federlasche, verbunden sind, oder mehrere zweite Kompressionselemente (4.1.2) und ein erstes Kompressionselement (4.1.1) nach Art eines Mäanders, insbesondere als gebogene Federlasche, verbunden sind.

2. Vorrichtung zur Positionierung und Sicherung (4, 4.1) nach Patentanspruch 1, **dadurch gekennzeichnet, dass** die Vorrichtung zur Positionierung und Sicherung (4, 4.1) einen Rahmen bildet.

3. Vorrichtung zur Positionierung und Sicherung (4, 4.1) nach einem der vorhergehenden Ansprüche, **dadurch gekennzeichnet, dass** die Vorrichtung zur Positionierung und Sicherung (4, 4.1) als ein rechteckiger Rahmen vorgesehen ist.

4. Vorrichtung zur Positionierung und Sicherung (4, 4.1) nach einem der vorhergehenden Ansprüche, **dadurch gekennzeichnet, dass** das Anzeigeelement (2) in einer Richtung senkrecht zu der Hauptausdehnungsebene an eine Blende des Gehäuses (5) stößt.

5. Anzeigevorrichtung (1), insbesondere für ein Kraftfahrzeug, **dadurch gekennzeichnet, dass** die Anzeigevorrichtung (1) eine Vorrichtung zur Positionierung und Sicherung (4, 4.1) nach einem der vorhergehenden Ansprüche aufweist und dass die Anzeigevorrichtung (1) ein Anzeigeelement (2) und ein Gehäuse (5) aufweist.

6. Anzeigevorrichtung (1) nach Anspruch 5, **dadurch gekennzeichnet, dass** das Anzeigeelement (2) mindestens ein Elektrolumineszenzelement vom Typ des Dünnfilmtransistors (TFT, thin film transistor) oder ein Flüssigkristall-Elektrolumineszenzelement (LCD, liquid crystal display) aufweist.

## Claims

1. Device (4, 4.1) for positioning and securing a display element (2) with respect to a housing (5), the display element (2) being essentially localized in one main extension plane and abutting with the housing (5) in a direction perpendicular to the main extension plane,
the positioning and securing device (4, 4.1) being essentially localized in another main extension plane parallel to the main extension plane of the display element (2),
**characterized in that** the positioning and securing device (4, 4.1) comprises at least one first compression element (4.1.1) abutting against the display element (2), as well as at least one second compression element (4.1.2) abutting against the housing (5), the positioning and securing device (4, 4.1) being made of an electrically conductive material, in particular a metal or a metal alloy, **characterized in that** the first compression element (4.1.1) and the second compression element (4.1.2) are connected to one another in the manner of a leaf spring and **in that** a plurality of first compression elements (4.1.1) and one second compression element (4.1.2) are connected in the manner of a meander, particularly in the form of a folded spring clip, or a plurality of second compression elements (4.1.2) and one first compression element (4.1.1) are connected in the manner of a meander, particularly in the form of a folded spring clip.

2. Positioning and securing device (4, 4.1) according to claim 1, **characterized in that** the positioning and securing device (4, 4.1) forms a frame.

3. Positioning and securing device (4, 4.1) according to either one of the preceding claims, **characterized in that** the positioning and securing device (4, 4.1) is provided as a rectangular frame.

4. Positioning and securing device (4, 4.1) according to any one of the preceding claims, **characterized in that** the display element (2) abuts with a diaphragm of the housing (5) in a direction perpendicular to the main extension plane.

5. Display device (1), in particular for an automobile, **characterized in that** the display device (1) comprises a positioning and securing device (4, 4.1) according to any one of the preceding claims, and **in that** the display device (1) comprises a display element (2) and a housing (5).

6. Display device (1) according to Claim 5, **characterized in that** the display element (2) comprises at least one electroluminescent element of the thin-film transistor type (TFT) or a liquid-crystal electroluminescent element (LCD, liquid crystal display).
